# EUROPÄISCHE PATENTSCHRIFT

(11) **EP 1 956 651 B1**
(45) Veröffentlichungstag und Bekanntmachung des Hinweises auf die Patenterteilung: **06.05.2009**
(21) Anmeldenummer: 08000990.5
(22) Anmeldetag: 19.01.2008
(51) Int. Cl.: H01L 23/48

(54) **Leistungshalbleitermodul mit Kontaktfedern**
Power semiconductor module with contact springs
Module semi-conducteur de puissance doté de ressorts de contact

(30) Priorität: 08.02.2007 DE 102007006212
(43) Veröffentlichungstag der Anmeldung: 13.08.2008
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Peteraurach (DE)

(56) Entgegenhaltungen:
- EP-A- 1 367 643
- EP-A- 1 450 404
- WO-A-20/05020383
- US-A1- 2004 102 063

## Beschreibung

Die Erfindung beschreibt ein kompaktes Leistungshalbleitermodul in Druckkontakttechnik mit als Kontaktfedern ausgebildeten Anschlusselementen. Moderne Ausgestaltungen derartiger Leistungshalbleitermodule mit hoher Leistung bezogen auf ihre Baugröße, die Ausgangspunkt dieser Erfindung sind, sind bekannt aus der DE 196 30 173 A1 oder der DE 103 06 643 A1.

Die DE 196 30 173 A1 offenbart ein Leistungshalbleitermodul zur direkten Montage auf einem Kühlkörper, bestehend aus einem Gehäuse und einem elektrisch isolierenden Substrat welches seinerseits aus einem Isolierstoffkörper mit einer Mehrzahl darauf befindlicher gegeneinander isolierter metallischer Verbindungsbahnen und darauf befindlichen und mit diesen Verbindungsbahnen schaltungsgerecht verbundenen Leistungshalbleiterbauelementen besteht. Die externe elektrische Verbindung zu einer außerhalb des Gehäuses angeordneten Leiterplatte erfolgt mittels zumindest teilweise federnd gestalteter Anschlusselemente.

Das Leistungshalbleitermodul weist weiterhin mindestens eine zentral angeordnete Ausnehmung zur Durchführung einer Schraubverbindung auf. Diese dient zusammen mit einem auf der dem Leistungshalbleitermodul abgewandeten Seite der Leiterplatte angeordneten und auf dieser flächig aufliegenden, formstabilen Druckstück der Druckkontaktierung des Moduls. Diese Druckkontaktierung erfüllt gleichzeitig zwei Aufgaben: einerseits die sichere elektrische Kontaktierung der Anschlusselemente mit der Leiterplatte und andererseits die thermische Kontaktierung des Moduls mit einem Kühlkörper, wobei beide Kontaktierungen reversibel sind.

Die DE 103 06 643 A1 offenbart die Anordnung eines oben genannten Leistungshalbleitermoduls mit einem speziell ausgestalteten Druckstück. Hierbei sind die Kontaktfedern doppel-Z-förmig ausgestaltet. Derartige Kontaktfedern sind beispielhaft als Stanz- Biege Formkörper aus einem flächigen Metallband hergestellt.

Die Kontaktfedern weist einen ersten Kontaktabschnitt zur Kontaktierung mit der Leiterplatte auf. Hierzu weist der flächige Formkörper der Kontaktfeder im Bereich dieses ersten Kontaktabschnitts eine Kröpfung auf. Der zweite Kontaktabschnitt zur Kontaktierung mit den Leiterbahnen des Substrats weist keine weitere Verformung auf. Hierbei wird der Kontakt durch das stumpf auf einer Leiterbahn aufstehende Ende des flächigen Formkörpers gebildet.

Die WO 2005/020383 A1 offenbart eine Druckkontaktfeder aus elektrisch leitfähigem Draht mit einem ersten Kontaktierungsbereich mit einer abgerundeten Kontaktspitze und einem zweiten Kontaktierungsbereich zum Kontaktieren einer zweiten elektrisch leitenden Kontaktstelle sowie einem dazwischen angeordneten Komprimierungsbereich mit mindestens einer Drahtkrümmung.

Nachteilig an den bekannten Ausgestaltungen der oben genannten Kontaktfeder ist, dass im Bereich der Kontaktstellen die Kanten der Kontaktfeder während des Betriebs die zugeordnete Kontaktstelle des Kontaktpartners beschädigen können und hierunter die Zuverlässigkeit der elektrischen Anschlüsse leidet. Dies ist darin begründet, dass im Betrieb eines Leistungshalbleiterbauelements dieses sich erwärmt und durch unterschiedliche Ausdehnungskoeffizienten die Kontaktflächen der Kontaktabschnitte und der Kontaktpartner sich zueinander bewegen. Diese thermische Bewegung der Kanten der Kontaktabschnitte die auch Vibrationen des Leistungshalbleitermoduls im Betrieb können somit die zugeordneten Kontaktflächen des Kontaktpartners beschädigen.

Der Erfindung liegt die Aufgabe zugrunde ein Leistungshalbleitermodul in Druckkontaktausführung mit Kontaktfedern ausgebildet als flächiger Metaltformkörper vorzustellen, wobei die Kontaktabschnitte der Kontaktfedern weitergebildet sind um die Zuverlässigkeit des hierdurch erzielten Kontakts zu verbessern.

Diese Aufgabe wird erfindungsgemäß gelöst, durch die Maßnahmen der Merkmale des Anspruchs 1. Bevorzugte Ausführungsformen sind in den Unteransprüchen beschrieben.

Ausgangspunkt der Erfindung ist ein Leistungshalbleitermodul in Druckkontaktierung der bekannten Art. Dieses auf einem Kühlbauteil anordenbare Leistungshalbleitermodul weist ein Substrat mit auf einer Hauptfläche dieses Substrats angeordneten Leiterbahnen auf. Auf mindestens einer dieser Leiterbahnen ist mindestens ein Halbleiterbauelement angeordnet.

Weiterhin weist das Leistungshalbleitermodul Anschlusselemente auf, die als vorzugsweise in einem Gehäuse lose fixierte Kontaktfedern ausgebildet sind auf. Die Kontaktfedern bildeten somit die Verbindung einer Leiterbahn oder einer Kontaktfläche eines Halbleiterbauelements zu Kontaktflächen eines Kontaktpartners, vorzugsweise einer außerhalb des Leistungshalbleitermoduls angeordneten Leiterplatte aus.

Die Kontaktfedern weisen hierzu einen ersten und einen zweiten Kontaktabschnitt auf, wobei die jeweilige Kontaktfeder hierbei als flächiger Metallformkörper ausgebildet ist. Die Kontaktabschnitte selbst weisen jeweils eine Kröpfung und orthogonal zu dieser Kröpfung eine weitere konvexe, als vom Kontaktpartner weggerichtete, Krümmung auf, wodurch.sich ein balliger Kontaktbereich des Kontaktabschnittes ausbildet.

Durch geeignete Ausbildung dieser weiteren Krümmung kann der Kontakt zwischen dem Rand der Kontaktfeder im Bereich der Kontaktabschnitt mit den Kontaktflächen des Kontaktpartners zumindest verringert oder gänzlich vermieden werden. Hierdurch wird auch eine Beschädigung der Kontaktflächen des Kontaktpartners im Betrieb stark reduziert oder vermieden. Somit wird die Zuverlässigkeit des Leistungshalbleitermoduls im Betrieb verbessert.

Besonders bevorzugte Weiterbildungen dieses Leistungshalbleitermoduls sind in der jeweiligen Beschreibung der Ausführungsbeispiele genannt. Die erfinderische Lösung wird zudem an Hand der Ausführungsbeispiele der Fig. 1 bis 3 weiter erläutert.

Fig. 1 zeigt in dreidimensionaler Darstellung einen Schnitt durch ein erfindungsgemäßes Leistungshalbleitermodul.

Fig. 2 zeigt in zweidimensionaler Darstellung einen Schnitt durch ein erfindungsgemäßes Leistungshalbleitermodul.

Fig. 3 zeigt Details der Ausgestaltung einer Kontaktfeder eines erfindungsgemäßen Leistungshalbleitermoduls.

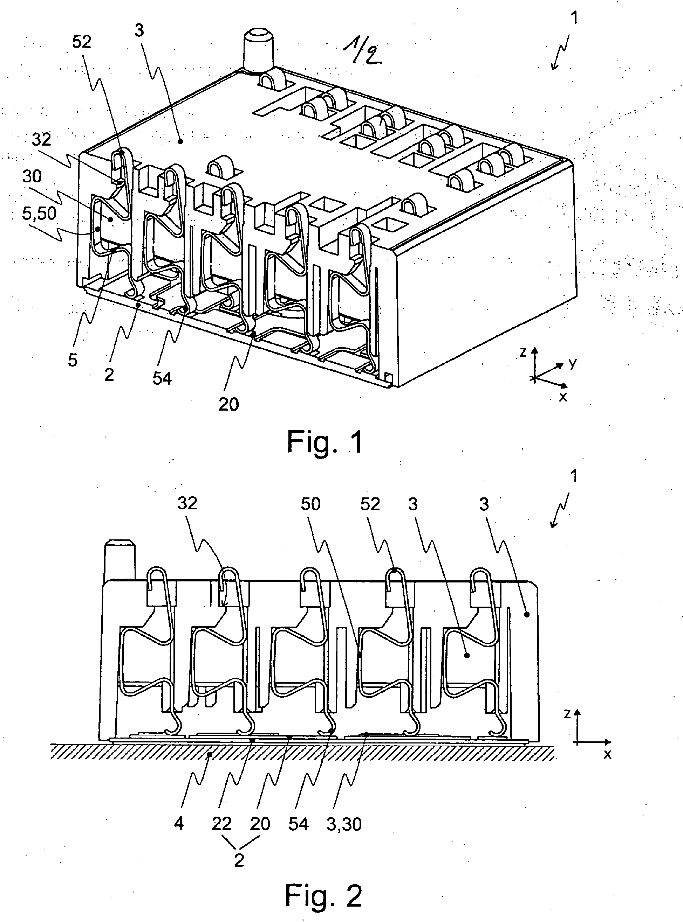

Fig. 1 und 2 zeigen in verschiedener Darstellung jeweils einen Schnitt durch ein erfindungsgemäßes Leistungshalbleitermodul (1). Dargestellt ist hier ein Leistungshalbleitermodul (1) zur Druckkontaktierung mit einem Gehäuse (2), einem Substrat (3) zur direkten Montage auf einem Kühlbauteil (4) und vom Inneren nach außen führenden Anschlusselementen. Diese Anschlusselemente sind als Kontaktfedern (5) ausgebildet. Die Erfindung ist allerdings nicht beschränkt auf diese spezielle Ausgestaltung des Leistungshalbleitermoduls. Beispielhaft können die Kontaktfedern auch als Verbindungselemente zwischen einem Substrat und einer im Inneren angeordneten Leiterplatte dienen.

Das Gehäuse.(1) weist zur Druckeinleitung auf die Kontaktfedern vorzugsweise eine zentral gelegene nicht dargestellte Ausnehmung nach dem Stand der Technik auf Mittels diese Ausnehmung und eines zugeordneten ebenfalls nicht dargestellten Druckkörper wird Druck auf die Kontaktfedern (5) und vorzugsweise auch auf das Gehäuse (3) aufgebaut. Dieser Druck sorgt für eine sicher thermisch leitende Verbindung zwischen dem Substrat (2) und einem Kühlbauteil (4). Ebenso sorgt dieser Druck für eine sichere elektrische Verbindung zwischen der Kontaktfeder (5) und der zugeordneten Leiterbahn (20) bzw der nicht dargestellten Kontaktfläche eines Halbleiterbauelements (3).

Das Substrat (2) besteht vorzugsweise aus einer isolierenden Schicht (22) und hierauf angeordneten Metallkaschierungen, die die Leiterbahnen (20) des Leistungshalbleitermoduls (1) ausbilden. Andere Substratvarianten können ebenfalls bevorzugt sein. Der Rand des Substrats (2) wird allseits durch das oben beschriebene Gehäuse (3) umschlossen und bildet mit diesem die Seitenflächen des Leistungshalbleitermoduls (1).

Das Gehäuse (1) weist weiterhin als Führungen ausgebildete Schächte (30) auf in denen jeweils ein Anschlusselement, eine Kontaktfeder(5), angeordnet sind. Die Kontaktfedern sind derart beweglich in diesen Schächten angeordnet, dass hierdurch die Druckeinleitung nicht behindert wird. Diese Kontaktfedern (5) weisen einen Grundkörper auf, der doppel-Z-förmig ausgestaltet ist. An dem ersten Kontaktabschnitt (52, Fig. 2) der Kontaktfeder (5) weist deren Ende eine Kröpfung (520, Fig. 2) auf. Diese dient mit einem Widerlager (32) in der Ausnehmung (30) des Gehäuses (3) als Sicherung gegen Herausfallen während des Herstellungsprozesses des Leistungshalbleitermoduls (1), da hier erst die Kontaktfeder (5) in dem Gehäuse (3) angeordnet werden, und anschließend das Substrat (2) zu diesem Montageverbund angeordnet wird.

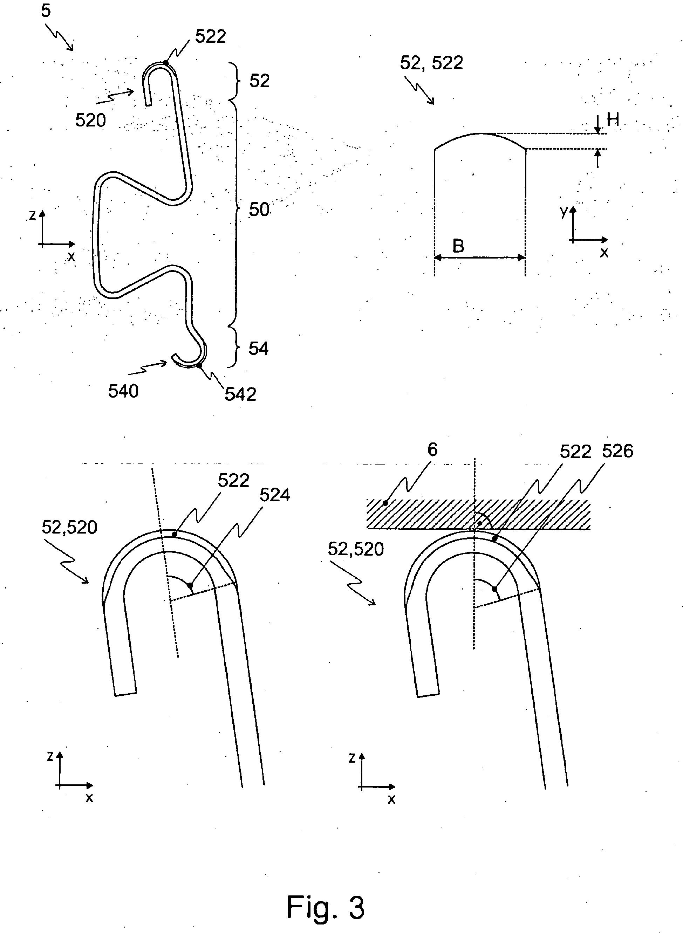

Vorzugsweise sind diese Kontaktfedern (5) als flächige Formkörper, vgl. Fig. 3, gebildet aus einem in Stanz- Biegetechnik hergestellten Metallband ausgebildet. Erfindungsgemäß weisen der erste und der zweite Kontaktabschnitt (522, 542, Fig. 2) dieser Kontaktfedern (5) je eine Kröpfung (520, 540, Fig. 2) und orthogonal zu dieser Kröpfung eine weitere konvexe Krümmung (522, 542, Fig. 2) auf.

Fig. 3 zeigt Details der Ausgestaltung einer Kontaktfeder (5) eines erfindungsgemäßen Leistungshalbleitermoduls (1). Vorzugsweise ist diese Kontaktfeder (5) als ein flächiger Metallformkörper ausgebildet, der mittels eines Stanz-Biegeverfahrens hergestellt wurde Hierbei entsteht der die Federfunktion bereitstellende Grundkörper (50) der Kontaktfeder (5) in seiner doppel-Z-förmig Ausgestaltung. Weiterhin sind die beiden Kontaktabschnitte (52, 54) an den jeweiligen Enden des Metallformkörpers mit einer Kröpfung (520, 540) ausgebildet. Hierbei ist es besonders vorteilhaft, wenn der Winkelbereich der Kröpfung zwischen 120 Grad und 190 Grad liegt.

Orthogonal zu dieser Kröpfung (520, 540) weisen beide Kontaktabschnitte (52, 54) eine weitere Krümmung (522, 542) auf. Hierbei ist es vorteilhaft, wenn die Höhendifferenz ..... (H) der Außenkante der Krümmung (522, 542) gegenüber der Mitte des ' Kontaktabschnitts (52, 54) zwischen Zwei und Zehn von Hundert der Breite (B) der Kontaktfeder beträgt. Bei einer beispielhaften Breite (B) der Kontaktfeder (5) von 2mm liegt somit die Außenkante zwischen 40pm und 200µm konvex zurückversetzt. '

Diese zusätzliche Krümmung (522, 542) weist vorteilhafterweise eine Winkelbereich (524) auf der größer ist als der halben Winkelbereich der zugeordneten Kröpfung (520, 540) und sich symmetrisch um deren Mitte erstreckt. Ebenso kann es besonders von Vorteil sein, wenn die Krümmung (522, 542) in einem Winkelbereich (526) von mindestens t20 Grad lotrecht zur Kontaktstelle, beispielhafte einer Leiterbahn (20 einer Kontaktfläche (30) eines Halbleiterbauelements (3) oder einer Leiterplatte (6) ausgebildet ist.

## Patentansprüche

1. Leistungshalbleitermodul (1) mit
einem Substrat (2),
auf einer Hauptfläche dieses Substrats (2) angeordneten Leiterbahnen (20), mindestens einem mit seiner ersten Hauptfläche auf einer ersten Leiterbahn angeordnetem Halbleiterbauelement (3),
als Kontaktfedern (5) ausgebildeten von einer Leiterbahn (20) oder einer Kontaktfläche (30) auf der zweiten Hauptfläche eines Halbleiterbauelements (3) ausgehenden Anschlusselementen,
wobei diese Kontaktfedern (5) einen ersten und einen zweiten Kontaktabschnitt (52, 54) aufweisen und
wobei die jeweilige Kontaktfeder (5) als flächiger Formkörper ausgebildet ist,
die Kontaktabschnitte (52, 54) eine Kröpfung (520, 540) aufweisen, **dadurch gekennzeichnet, daß** die Kontaktabschnitte (52,54) orthogonal zu dieser Kröpfung (520, 540) eine weitere konvexe Krümmung (522, 542) aufweisen und
wobei die konvexe Krümmung in einem Winkelbereich (526) von mindestens ±20 Grad lotrecht zur Kontaktstelle (6, 20, 30) ausgebildet ist und die Kontaktabschnitte jeweils einen balligen Kontaktbereich ausbilden.

2. Leistungshalbleitermodul nach Anspruch 1,
wobei die Kontaktfedern (5) von den Leiterbahnen (20) des Substrats (2) oder den Kontaktflächen (30) der Halbleiterbauelemente (3) nach außen führen

3. Leistungshalbleitermodul nach Anspruch 1,
wobei der flächige Formkörper der Kontaktfeder (5) aus einem in Stanz- Biegetechnik ausgebildeten Metallband besteht.

4. Leistungshalbleitermodul nach Anspruch 1,
wobei der Grundkörper der Kontaktfeder (5) doppel-Z-förmig ausgestaltet ist.

5. Leistungshalbleitermodul nach Anspruch 1,
wobei die Höhendifferenz (H) der Außenkante der Krümmung (522, 542) gegenüber der Mitte des Kontaktabschnitts (52, 54) zwischen Zwei und Zehn von Hundert der Breite (B) der Kontaktfeder beträgt.

6. Leistungshalbleitermodul nach Anspruch 1,
wobei der Winkelbereich der Kröpfung (520) zwischen 120 Grad und 190 Grad liegt.

7. Leistungshalbleitermodul nach Anspruch 4,
wobei der Winkelbereich (524) der Krümmung (522, 542) über mindestens den halben Winkelbereich der Kröpfung (520) ausgebildet ist.

## Claims

1. A power semiconductor module (1) comprising a substrate (2), conductor paths (20) disposed on a principal surface or this substrate (2), at least one semiconductor component (3) disposed with its first principal surface on a first conductor path, connection elements configured as contact springs (5) emanating from a conductor path (20) or a contact area (30) on the second principal surface of a semiconductor component (3),
wherein these contact springs (5) comprise a first and a second contact section (52, 54) and
wherein the respective contact spring (5) is configured as a flat shaped body, the contact sections (52, 54) halve an offset (520, 540), **characterised in that** orthogonal to this offset (520, 540) the contact sections (52, 54) halve a further convex curvature (522, 542) and wherein the convex curvature is configured in an angular range (526) of at least ±20 degrees perpendicular to the contact point (6, 20, 30 and the contact sections each form a spherical contact region.

2. The power semiconductor module according to claim 1, wherein the contact springs (5) lead outwards from the conductor paths (20) of the substrate (2) or the contact surfaces (30) of the semiconductor components (3).

3. The power semiconductor module according to claim 1, wherein the flat shaped body of the contact spring (5) consists of a metal strip formed by stamping-bending technology.

4. The power semiconductor module according to claim 1, wherein the base body of the contact spring (5) is configured as double Z-shaped.

5. The power semiconductor module according to claim 1, wherein the height difference (H) of the outer edge of the curvature (522, 542) with respect to the centre of the contact section (52, 54) is between two and ten hundredths of the width (B) of the contact spring.

6. The power semiconductor module according to claim 1, wherein the angular range of the offset (520) lies between 120 degrees and 190 degrees.

7. The power semiconductor module according to claim 4, wherein the angular range (524) of the curvature (522, 542) is formed over at least half the angular range of the offset (520).

## Revendications

1. Module semiconducteur de puissance (1) avec
un substrat (2),
des pistes conductrices (20) disposées sur une surface principale de ce substrat (2),
au moins un composant semiconducteur (3) disposé par sa première surface principale sur une première piste conductrice,
des éléments de raccordement prenant la forme de ressorts de contact (5), issus d'une piste conductrice (20) ou d'une surface de contact (30) sur la seconde surface principale d'un composant semiconducteur (3),
ces ressorts de contact (5) possédant un premier et un second segment de contact (52, 54) et
les différents ressorts de contact (5) ayant une configuration de corps de forme plate et les segments de contact (52, 54) possédant un coude (520, 540),
**caractérisé en ce que** les segments de contact (52, 54) possèdent, orthogonalement à ce coude (520, 540), une autre courbure convexe (522, 542) et dans lequel la courbure convexe, sur une plage angulaire (526) d'au moins ± 20 degrés, est réalisée perpendiculaire au point de contact (6, 20, 30) et les segments de contact forment chacun une zone de contact en forme de bille.

2. Module semiconducteur de puissance selon la revendication 1, dans lequel les ressorts de contact (5) conduisent vers l'extérieur à partir des pistes conductrices (20) du substrat (2) ou des surfaces de contact (30) des composants semiconducteurs (3).

3. Module semiconducteur de puissance selon la revendication 1, dans lequel le corps de forme plate du ressort de contact (5) se compose d'un ruban métallique usiné par une technologie d'estampage et de pliage.

4. Module semiconducteur de puissance selon la revendication 1, dans lequel le corps de base du ressort de contact (5) est réalisé en forme de double Z.

5. Module semiconducteur de puissance selon la revendication 1, dans lequel la différence de hauteur (H) entre l'arête extérieure de la courbure (522, 542) et le centre du segment de contact (52, 54) est comprise entre deux et dix pour cent de la largeur (B) du ressort de contact.

6. Module semiconducteur de puissance selon la revendication 1, dans lequel la plage angulaire du coude (520) se situe entre 120 degrés et 190 degrés.

7. Module semiconducteur de puissance selon la revendication 4, dans lequel la plage angulaire (524) de la courbure (522, 542) représente au moins la moitié de la plage angulaire du coude (520).
